# EUROPEAN PATENT APPLICATION

(11) **EP 2 492 916 A1**
(43) Date of publication of application: **29.08.2012**
(21) Application number: 11786096.5
(22) Date of filing: 27.05.2011
(51) Int. Cl.: G11C 7/10

(54) **MULTI-INTERFACE SOLID STATE DISK (SSD), PROCESSING METHOD AND SYSTEM THEREOF**

(30) Priority: 27.05.2010 CN 201010184698
(71) Applicant: Huawei Technologies Co., Ltd., Shenzhen, Guangdong 518129 (CN)
(72) Inventor: TONG, Chaozhu, Shenzhen Guangdong 518129 (CN); LI, Minqiu, Shenzhen Guangdong 518129 (CN)
(74) Representative: Thun, Clemens
(86) International application number: PCT/CN2011/074760
(87) International publication number: WO 2011/147324

(57) **Abstract**

Embodiments of the present invention disclose a multi-interface solid state disk, and a processing method and system of the multi-interface solid state disk, and relate to the field of communications, so that multiple hosts can share and access the SSD directly, and requirements of each host for high performance, wide bandwidth and high capacity of the SSD are satisfied. The multi-interface solid state disk according to the present invention includes: multiple interface control units, a command scheduling unit, a flash control unit and a flash chip. Each interface control unit corresponds to a communication interface respectively. The interface control unit receives an operating command through the communication interface. The command scheduling unit obtains, according to a scheduling rule, operating commands from the multiple interface control units, puts the operating commands in a command queue, takes an operating command from the command queue, and sends the operating command to the flash control unit. The flash control unit converts the operating command into a flash operating command to operate the flash chip.

## Description

This application claims priority to Chinese Patent Application No. 201010184698.9, filed with the Chinese Patent Office on May 27, 2010 and entitled "MULTI-INTERFACE SOLID STATE DISK, PROCESSING METHOD AND SYSTEM OF MULTI-INTERFACE SOLID STATE DISK", which is incorporated herein by reference in its entirety.

### FIELD OF THE INVENTION

The present invention relates to the field of communications, and in particular, to a multi-interface solid state disk, and a processing method and system of the multi-interface solid state disk.

### BACKGROUND OF THE INVENTION

An SSD (Solid State Disk, solid state disk) uses a flash (flash) as a storage medium. Compared with a conventional hard disk, the SSD has advantages of fast data access, shockproof and anti-fall, low power consumption, durable in use, noiseless, and light and thin in appearance. In some special application scenarios, the SSD has a good prospect to replace the conventional hard disk. An SSD disk of a general SATA (Serial Advanced Technology Attachment, serial advanced technology attachment) 3.0 interface is restricted by a bandwidth of the SATA 3.0 interface and is usually incapable of exerting its maximum performance. In comparison, an SSD based on a PCIe (Peripheral Component Interconnect Express, peripheral component interconnect express) interface has advantages of a larger capacity and higher performance, and may be well applied in a field having higher requirements on capacity and performance.

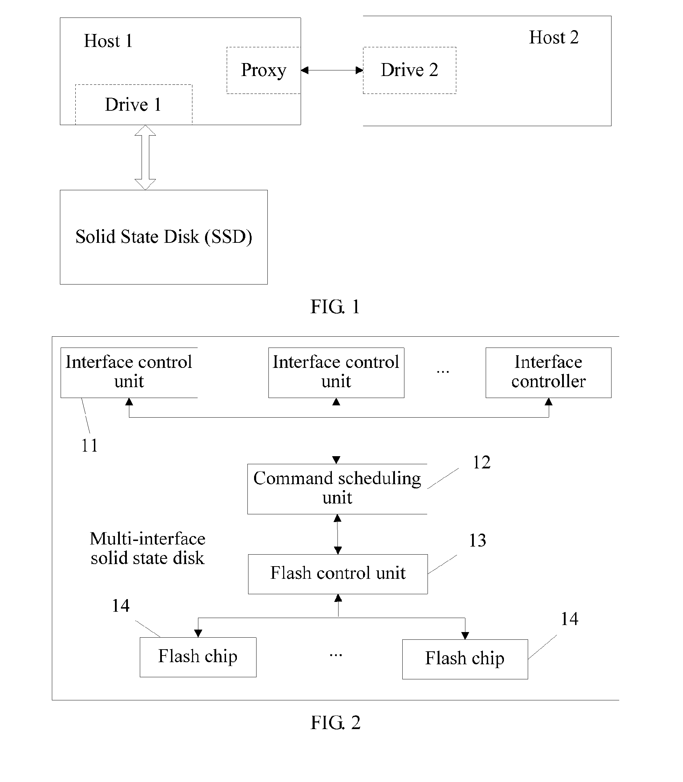

Currently, on the market, an SSD having a PCIe interface is always an SSD having a single PCIe interface. As shown in FIG. 1, an SSD and a host 1 (for example, a PC machine, or a server) are connected through a PCIe interface. The host 1 uses the SSD as its own storage device through a drive 1, and may directly access the SSD. A host 2 delivers an access command regarding the SSD to the SSD through a drive 2 and a proxy module that runs on the host 1 and then through the drive 1 on the host 1, thus implementing indirect access to the SSD.

In the process of implementing sharing and accessing the SSD by the multiple hosts, the inventors find that the prior art has at least the following problems:

The SSD having a single PCIe interface can be inserted in only one host and can be directly accessed by only one host. Other hosts can only access the SSD indirectly. Therefore, an access bandwidth of a host that accesses the SSD indirectly is small, and an access delay is large. Requirements of each host for high performance, wide bandwidth and high capacity of the SSD cannot be well satisfied.

### SUMMARY OF THE INVENTION

Embodiments of the present invention provide a multi-interface solid state disk, and a processing method and system of the multi-interface solid state disk, so as to solve the technical problem in the prior art that an SSD can be directly accessed by only one host and cannot be directly shared and accessed by multiple hosts, which results in that requirements of each host for high performance, wide bandwidth and high capacity of the SSD cannot be satisfied.

In order to achieve the foregoing objectives, the embodiments of the present invention adopt the following technical solutions:

A multi-interface solid state disk includes multiple interface control units, a command scheduling unit, a flash control unit and a flash chip, and each interface control unit respectively corresponds to a communication interface.

The interface control unit is configured to receive an operating command through the communication interface.

The command scheduling unit is configured to obtain operating commands from the multiple interface control units according to a scheduling rule, and put the operating commands in a command queue;

The command scheduling unit is further configured to take an operating command from the command queue and send the operating command to the flash control unit.

The flash control unit is configured to convert the received operating command into a flash operating command and operate the flash chip through the flash operating command.

A processing method of a multi-interface solid state disk includes:
receiving operating commands through multiple communication interfaces;
obtaining, according to a scheduling rule, the operating commands received from the multiple communication interfaces, and putting the operating commands in a command queue;
taking an operating command from the command queue; and
converting the operating command into a flash operating command, and operating a flash chip in the solid state disk.

A processing system of a multi-interface solid state disk includes at least one host and at least one multi-interface solid state disk.

The host includes a multi-interface solid state disk drive, where a direct communication connection between the host and the multi-interface solid state disk is achieved through running of the drive, and the host is configured to send an operating command to the multi-interface solid state disk.

The multi-interface solid state disk includes multiple interface control units, a command scheduling unit, a flash control unit and a flash chip. Each interface control unit respectively corresponds to a communication interface. The interface control unit is configured to receive, through the communication interface, the operating command sent by the host. The command scheduling unit is configured to obtain operating commands from the multiple interface control units according to a scheduling rule, and put the operating commands in a command queue. The command scheduling unit is further configured to take an operating command from the command queue and send the operating command to the flash control unit. The flash control unit is configured to convert the received operating command into a flash operating command and operate the flash chip through the flash operating command.

According to the multi-interface solid state disk, and the processing method and system of an operating command that are provided in the embodiments of the present invention, multiple communication interfaces are disposed in a solid state disk, so that different hosts may be directly connected to a solid state disk interface for communication through different communication interfaces, thus avoiding the problem that when multiple hosts share the SSD, except a host that is directly connected to the SSD, other hosts need to access the SSD indirectly, so that different hosts may directly access the solid state disk concurrently, and do not need to perform accessing by a sharing manner between each other. Therefore, an access bandwidth is increased and the requirements of each host for features, such as high performance, wide bandwidth and high capacity, of the SSD are satisfied.

### BRIEF DESCRIPTION OF THE DRAWINGS

To illustrate the technical solutions according to the embodiments of the present invention or in the prior art more clearly, accompanying drawings required for describing the embodiments or the prior art are introduced below briefly. Apparently, the accompanying drawings in the following descriptions are merely some embodiments of the present invention, and persons of ordinary skill in the art may further obtain other drawings according to the accompanying drawings without creative efforts.

FIG. 1 is a structural block diagram of a processing system of a solid state disk in the prior art;

FIG. 2 is a structural block diagram of a multi-interface solid state disk according to a first embodiment of the present invention;

FIG. 3 is a structural block diagram of a multi-interface solid state disk according to second embodiment of the present invention;

FIG. 4 is a flow chart of a processing method of a multi-interface solid state disk according to a third embodiment of the present invention;

FIG. 5 is a flow chart of another processing method of a multi-interface solid state disk according to the third embodiment of the present invention;

FIG. 6 is a structural block diagram of a processing system of a multi-interface solid state disk according to a fourth embodiment of the present invention;

FIG. 7 is a structural block diagram of another processing system of a multi-interface solid state disk according to the fourth embodiment of the present invention; and

FIG. 8 is a structural block diagram of another processing system of a multi-interface solid state disk according to the fourth embodiment of the present invention.

### DETAILED DESCRIPTION OF THE EMBODIMENTS

The technical solutions according to the embodiments of the present invention are clearly and completely described in the following with reference to the accompanying drawings in the embodiments of the present invention. Obviously, the embodiments to be described are only part of rather than all of the embodiments of the present invention. All other embodiments obtained by persons of ordinary skill in the art based on the embodiments of the present invention without creative efforts shall fall within the protection scope of the present invention.

### Embodiment 1

An embodiment of the present invention provides a multi-interface solid state disk, which, as shown in FIG. 2, includes multiple interface control units 11, a command scheduling unit 12, a flash control unit 13 and flash chips 14.

Each of the interface control units 11 respectively corresponds to a communication interface. The interface control unit 11 is configured to receive an operating command through the communication interface. Specifically, the communication interface may be a PCIe interface or a SATA interface. The operating command received by the interface control unit 11 is from various hosts connected to a hard disk card, such as a PC and a server, which is not limited here.

The command scheduling unit 12 is configured to obtain operating commands from the multiple interface control units 11 according to a scheduling rule, and put the operating commands in a command queue. Specifically, the command scheduling unit 12 may schedule the operating commands in the multiple interface control units 11 according to a polling principle of the multiple communication interfaces, or according to a principle regarding numbers of the multiple communication interfaces in which a lower number has the priority or a higher number has the priority, or according to other principles that are defined by a user, which is not limited here.

The command scheduling unit 12 is further configured to take an operating command from the command queue and send the operating command to the flash control unit 13. Specifically, when the operating command is taken from the command queue, the operating command is taken in sequence according to a first-in-first-out rule of the command queue.

The flash control unit 13 is configured to convert the received operating command into a flash operating command, and operate the flash chips 14 through the flash operating command. Specifically, the flash chips here may adopt an NAND (NAND) flash to achieve better performance. Because a command directly received through an interface control unit is incapable of directly operating a flash chip, the operating command needs to be converted by the flash control unit 13 into the flash operating command before operating the flash chip, such as data reading or data writing or other control operations.

In the embodiment of the present invention, multiple communication interfaces are disposed in a solid state disk, so that different hosts may be directly connected to a solid state disk interface for communication through different communication interfaces, thus avoiding the problem that when multiple hosts share the SSD, except a host that is directly connected to the SSD, other hosts need to access the SSD indirectly, so that different hosts may directly access the SSD concurrently, and do not need to perform accessing by a sharing manner between each other. Therefore, an access bandwidth of the host is increased, and the requirements of each host for high performance, wide bandwidth and high capacity of the SSD are satisfied.

### Embodiment 2

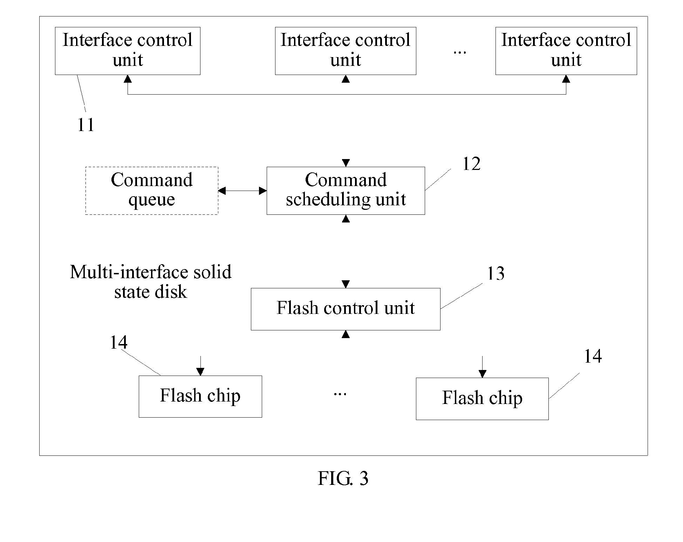

An embodiment of the present invention provides a multi-interface solid state disk, which, as shown in FIG. 3, includes multiple interface control units 11, a command scheduling unit 12, a flash control unit 13 and flash chips 14.

Each of the interface control units 11 respectively corresponds to a communication interface. The interface control unit 11 is configured to receive an operating command through the communication interface.

Specifically, the multiple communication interfaces may be PCIe interfaces, which, however, is not limited in the embodiment of the present invention. The communication interfaces may also be SATA interfaces. According to features of the PCIe interfaces and the SATA interfaces, a transmission bandwidth between a host and the SSD may be increased by setting the multiple communication interfaces to be PCIe interfaces compared with by using SATA interfaces, thus satisfying a field with high requirements on bandwidth performance, which, however, is not limited in the embodiment of the present invention. An interface type of the multiple communication interfaces may be set flexibly according to requirements of a user. For example, in order to be compatible to hosts having different types of interfaces, part of the multiple communication interfaces are set to be PCIe interfaces and the other part of the multiple communication interfaces are set to be SATA interfaces; in order to be adaptive to an application field having low requirements on a bandwidth, both of the two communication interfaces may also be set to be SATA interfaces; for an application field having high requirements on the transmission bandwidth and the transmission performance, all of the multiple communication interfaces may be set to be PCIe interfaces.

The interface control unit 11 is configured to receive the operating command through the communication interface, for example, to receive an operating command from a host through a PCIe interface or a SATA interface, where the operating command may be a read or a write command, and may also be a command with a maintenance function, such as a log query command, bad block count and query command or a command querying the number of times of data block erasing in a flash, which is not limited in the embodiment of the present invention.

In the embodiment of the present invention, the command scheduling unit 12 obtains operating commands from the multiple interface control units 11 according to a scheduling rule and put the operating commands in a command queue.

Specifically, when the command scheduling unit 12 obtains the operating commands from the multiple interface control units 11 according to the scheduling rule and put the operating commands in the command queue, the following method may be adopted, where the method includes:

The command scheduling unit 12 sends an obtaining command for obtaining an operating command to the multiple interface control units according to the scheduling rule. After receiving the obtaining command sent by the command scheduling unit, the interface control units send the operating commands to the command scheduling unit 12. The command scheduling unit 12 puts the received operating commands in the command queue. Specifically, the command scheduling unit 12 may schedule the operating commands of the multiple interface control units 11 according to a polling principle of the multiple communication interfaces, or according to a principle regarding numbers of the multiple communication interfaces in which a lower number has the priority or a higher number has the priority, which is not limited here. Apart from the foregoing scheduling rules, the command scheduling unit 12 may also use other self-defined scheduling rules according to requirements of a user, which is not limited in the embodiment of the present invention.

For example, when the command scheduling unit 12 obtains the operating commands from the multiple interface control units 11 according to the polling principle of the multiple communication interfaces and puts the operating commands in the command queue, the following may be specifically included:

After two interface control units (namely, an interface control unit 1 and an interface control unit 2) of the multi-interface SSD respectively receive, through corresponding communication interfaces, operating commands (namely, a command 1 and a command 2) sent by a host 1 and a host 2, the command scheduling unit 12 sends read commands for obtaining the operating commands to the interface control unit 1 and the interface control unit 12 according to a predetermined cycle. After receiving the read commands, the interface control unit 1 and the interface control unit 2 deliver the operating commands temporally stored by the interface control unit 1 and the interface control unit 2 to the command scheduling unit 12. The command scheduling unit 12 puts the received command 1 in the command queue first, and then puts the received command 2 in the command queue.

For example, when the command scheduling unit 12 obtains the operating commands from the multiple interface control units 11 according to the principle regarding numbers of the multiple communication interfaces, in which the lower number has the priority, and puts the operating commands in the command queue, the following may be specifically included:

After two interface control units (namely, an interface control unit 1 and an interface control unit 2) of the multi-interface SSD respectively receive, through corresponding communication interfaces, operating commands (namely, a command 1 and a command 2) sent by a host 1 and a host 2, the command scheduling unit 12 sends read commands for obtaining the operating commands to the interface control unit 1 and the interface control unit 2 in sequence according to an ascending order of numbers of the two communication interfaces or a descending order of numbers of the two communication interfaces. After receiving the read commands, the interface control unit 1 and the interface control unit 2 deliver the operating commands temporally stored by the interface control unit 1 and the interface control unit 2 to the command scheduling unit. The command scheduling unit puts the received command 1 in the command queue first, and then puts the received command 2 in the command queue.

For example, when the command scheduling unit 12 obtains the operating commands from the multiple interface control units 11 according to the principle regarding numbers of the multiple communication interfaces, in which the higher number has the priority, and puts the operating commands in the command queue, the following may be specifically included:

After two interface control units (namely, an interface control unit 1 and an interface control unit 2) of the multi-interface SSD respectively receive, through corresponding communication interfaces, operating commands (namely, a command 1 and a command 2) sent by a host 1 and a host 2, the command scheduling unit 12 sends read commands for obtaining the operating commands to the corresponding interface control unit 2 and the interface control unit 1 in sequence according to a descending order of numbers of the two communication interfaces. After receiving the read commands, the interface control unit 2 and the interface control unit 1 deliver the operating commands temporally stored by the interface control unit 2 and the interface control unit 1 to the command scheduling unit. The command scheduling unit puts the received command 2 in the command queue first, and then puts the received command 1 in the command queue.

Furthermore, when it is required to execute the operating commands, the command scheduling unit 12 is further configured to take a previously-queued operating command from the command queue and send the previously-queued operating command to the flash control unit 13. Specifically, when the operating command is taken from the command queue, the operating command is taken out in sequence according to a first-in-first-out rule of the command queue.

The command scheduling unit 12 is physically disposed with inlet ports, the number of which corresponds to that of the interface control units, and an outlet port. Each of the inlet ports is respectively connected to an outlet port of an interface control unit corresponding to each of the inlet ports. The outlet port is connected to an inlet port of the flash control unit. The command scheduling unit 12 obtains the operating commands from the multiple interface control units 11 according to the scheduling rule, puts the operating commands in the command queue through the inlet port and sends an operating command to the flash control unit through the outlet port after taking the operating command from the command queue.

The flash control unit 13 is configured to convert the received operating command into a flash operating command and operate the flash chip 14 through the flash operating command.

Specifically, the flash control unit 13 receives the operating command, converts the operating command into the flash operating command and sends the flash operating command to the flash chip 14. Specifically, the flash chip here may adopt a NAND flash, so as to achieve better performance. Because a command received through an interface control unit is incapable of directly operating a flash chip, the operating command needs to be converted by the flash control unit 13 into the flash operating command before operating the flash chip, such as data reading or data writing.

Additionally, according to requirements on capacity, the flash control unit 13 may be connected to one or multiple flash chips 14. Alternatively, according to the embodiment of the present invention, multiple flash control units may also be included. Each flash controller is connected to one or more flash chips. Each flash control unit is connected to the command scheduling unit 12 through a bus.

Furthermore, it should be noted that, after the command scheduling unit 12 takes an operating command from the command queue, the command scheduling unit 12 is further configured to judge whether the operating command is formed by multiple commands. If it is judged that the operating command is formed by multiple commands, the operating command is divided into multiple commands, and the multiple commands are sent to the flash control unit. If it is judged that the operating command is formed by one command, the command is sent to the flash control unit.

Moreover, when the operating command received by the flash control unit 13 includes multiple commands, the multiple commands are converted into multiple corresponding flash operating commands respectively, and the multiple flash operating commands are sent to the flash chip respectively, so that the flash chip processes the multiple flash operating commands in parallel. When the operating command received by the flash control unit 13 includes one command, the command is converted into a corresponding flash operating command, and the flash operating command is sent to the flash chip for processing.

Furthermore, when the flash chip finishes execution of the operating command, an execution result of the operating command is returned to the command scheduling unit 12, so that the command scheduling unit 12 ends the execution of the corresponding operating command. The command scheduling unit 12 receives the execution result of the operating command and returns the execution result of the operating command to the host through the corresponding interface control unit 11.

Specifically, when the execution result of the operating command is returned to the host through the corresponding interface control unit, the execution result may be returned to the host directly through the corresponding interface control unit by adopting an interrupting manner; alternatively, the execution result may be sent to the corresponding interface control unit, and the host periodically detects whether an execution result of an operating command is stored in the interface control units, where if it is detected that an execution result of an operating command is stored in an interface control unit, the host obtains the execution result. The present invention does not make limitations upon the specific implementation. Which manner is to be specifically adopted may be specifically determined according to specific situations.

Specifically, when the multiple commands that form the operating command are executed concurrently, the command completely executed first is returned to the command scheduling unit first, so that the command scheduling unit ends the execution of the command.

In the embodiment of the present invention, the foregoing units may be implemented through various hardware processing chips. For example, the foregoing interface control unit and the command scheduling unit may be implemented by using a PLD (Programable Logic Device, programable logic device) chip (such as an FPGA (Field-Programmable Gate Array, field-programmable gate array), or a CPLD (Complex Programmable Logic Device, complex programmable logic device)), and the flash control unit is implemented through another PLD chip. Or, each of the units is individually implemented by using a PLD chip, which is not limited here.

In the embodiment of the present invention, multiple communication interfaces are disposed in a solid state disk, so that different hosts may be directly connected to a solid state disk interface for communication through different communication interfaces, thus avoiding the problem that when multiple hosts share the SSD, except a host that is directly connected to the SSD, other hosts need to access the SSD indirectly, so that different hosts may directly access the solid state disk concurrently, and do not need to perform accessing by a sharing manner between each other. Therefore, an access bandwidth is increased and requirements of each host for features, such as high performance, wide bandwidth and high capacity, of the SSD are satisfied.

Moreover, when the interfaces of the multi-interface SSD in the embodiment of the present invention are PCIe interfaces, the access bandwidth is further increased based on the performance of the PCIe interfaces compared with other interfaces, so that the hosts are enabled to make full use of the features, such as high performance, wide bandwidth and high capacity, of the SSD. Therefore, the performance of the system is increased to a large extend.

Furthermore, after the received operating command sent by the host is taken from the command queue, it is judged whether the operating command is formed by multiple commands. If it is judged that the operating command is formed by multiple commands, the operating command is divided into multiple commands, and the multiple commands are delivered at the same time, so that the multiple commands are processed in parallel, thus increasing the command processing speed. Moreover, after processing of one of the multiple commands that are processed in parallel is completed first, a processing result may be returned to the command scheduling unit first, so that the command scheduling unit ends the execution of the command, and therefore the SSD is enabled to have idle channels as many as possible inside for the processing of the other commands, thus improving the performance of the SSD.

### Embodiment 3

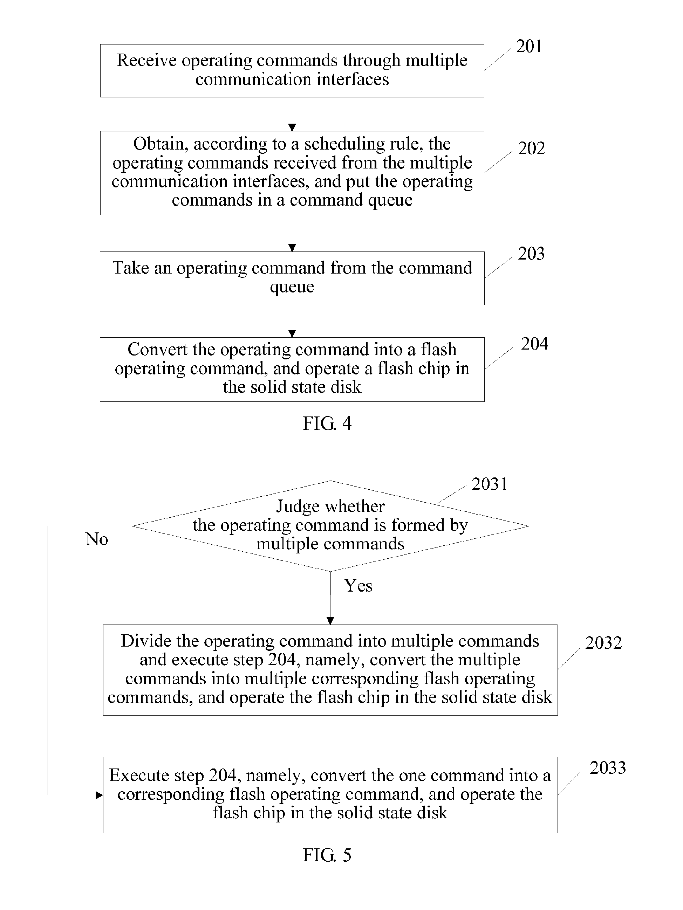

An embodiment of the present invention provides a processing method of a multi-interface solid state disk. As shown in FIG. 4, the method includes:

Step 201: Receive operating commands through multiple communication interfaces.

Specifically, in the embodiment of the present invention, the multi-interface solid state disk is disposed with multiple interface control units. Each of the interface control units corresponds to a type of communication interface. The received operating commands are from hosts, and are used to operate a flash inside the SSD.

Furthermore, after the operating commands are received, the operating commands are temporally stored in the interface control units to wait to be scheduled subsequently.

Step 202: Obtain, according to a scheduling rule, the operating commands received from the multiple communication interfaces, and put the operating commands in a command queue.

Specifically, a command scheduling unit of the SSD may be used to perform scheduling according to the scheduling rule and put the operating commands in the command queue, which may specifically include the following steps:

The command scheduling unit sends an obtaining command for obtaining the operating command to the multiple interface control units according to the scheduling rule. After receiving the obtaining command, the interface control units send the operating commands to the command scheduling unit. The command scheduling unit puts the received operating commands in the command queue.

The command scheduling unit may schedule the operating commands in the multiple interface control units according to a polling principle of the multiple communication interfaces, or according to a principle regarding numbers of the multiple communication interfaces in which a lower number has the priority or a higher number has the priority. Apart from the foregoing scheduling rules, in the embodiment of the present invention, other self-defined scheduling rules may be used according to requirements of a user, which is not limited in the embodiment of the present invention.

For the specific implementation of scheduling, by the command scheduling unit, the operating commands in the multiple interface control units according to various scheduling algorithms, reference may be made to the corresponding description in the second embodiment, which is not repeatedly described here.

Step 203: Take an operating command from the command queue.

Specifically, when the operating command is taken from the command queue, the operating command is taken out in sequence according to a first-in-first-out principle of the command queue.

Step 204: Convert the operating command into a flash operating command, and operate a flash chip in the solid state disk.

It should be noted that, after step 203, as shown in FIG. 5, the method may further include the following steps:

Step 2031: Judge whether the operating command is formed by multiple commands; if it is judged that the operating command is formed by multiple commands, execute step 2032; if it is judged that the operating command is formed by one command, execute step 2033.

Step 2032: Divide the operating command into multiple commands and execute step 204. That is, the multiple commands are converted into multiple corresponding flash operating commands to operate the flash chip in the solid state disk.

Step 2033: Execute step 204. That is, the one command is converted into a corresponding flash operating command to operate the flash chip in the solid state disk.

Specifically, the flash chip here may adopt an NAND flash, so as to achieve better performance. Because the operating command received through the communication interface is incapable of directly operating the flash chip, the operating command needs to be converted into the flash operating command before operating the flash chip, such as data reading or data writing or other control operations.

It should be noted that, after step 204, the method may further include:

An execution result of the operating command is returned to the command scheduling unit, so that the command scheduling unit ends the execution of the corresponding operating command. The command scheduling unit receives the execution result of the operating command and returns the execution result of the operating command to the host through the corresponding interface control unit.

Specifically, when the execution result of the operating command is returned to the host through the corresponding interface control unit, the execution result may be returned to the host directly through the corresponding interface control unit by adopting an interrupting manner; alternatively, the execution result may be sent to the corresponding interface control unit, and the host periodically detects whether an execution result of an operating command is stored in the interface control units, where if it is detected that an execution result of an operating command is stored in an interface control unit, the host obtains the execution result. The present invention does not make limitations upon the specific implementation. Which manner is to be specifically adopted may be specifically determined according to specific situations.

Specifically, when the multiple commands that form the operating command are executed concurrently, the command completely executed first is returned to the command scheduling unit first, so that the command scheduling unit ends the execution of the command.

Specifically, reference may be made to related descriptions in the first embodiment and the second embodiment for the specific implementation of the foregoing steps, which is not repeatedly described here.

In the embodiment of the present invention, when the hosts send the operating commands to the solid state disk through the multiple communication interfaces of the solid state disk, the multiple independently-disposed interface control units receive the operating commands, and the command scheduling unit schedules and puts the received operating commands in the command queue according to the scheduling rule, so that the received operating commands have an operating sequence. When the operating command needs to be operated, the operating command is taken from the command queue and sent to the flash control unit, so that the operating command is controlled and processed, and therefore an operation result is obtained. Therefore, different hosts are enabled to be directly connected to a solid state disk interface for communication through different communication interfaces, thus avoiding the problem that when multiple hosts share the SSD, except a host that is directly connected to the SSD, other hosts need to access the SSD indirectly, so that different hosts may directly access the solid state disk concurrently. Therefore, an access bandwidth is increased and requirements of each host for features, such as high performance, wide bandwidth and high capacity, of the SSD are satisfied.

Furthermore, after the received operating command sent by the host is taken from the command queue, it is judged whether the operating command is formed by multiple commands. If it is judged that the operating command is formed by multiple commands, the operating command is divided into multiple commands, and the multiple commands are delivered at the same time, so that the multiple commands are processed in parallel, thus increasing the command processing speed. Moreover, after processing of one of the multiple commands that are processed in parallel is completed, a processing result may be returned to the command scheduling unit first, so that the command scheduling unit ends the execution of the command, and therefore the SSD is enabled to have idle channels as many as possible inside for the processing of the other commands, thus improving the performance of the SSD.

### Embodiment 4

An embodiment of the present invention provides a processing system of a multi-interface solid state disk, where the system includes at least one host and a multi-interface SSD. When the host is one host, the host is a host that may be connected to at least two communication interfaces of the multi-interface SSD. When the hosts are multiple hosts, the hosts each are a host that may be connected to at least one communication interface of the multi-interface SSD.

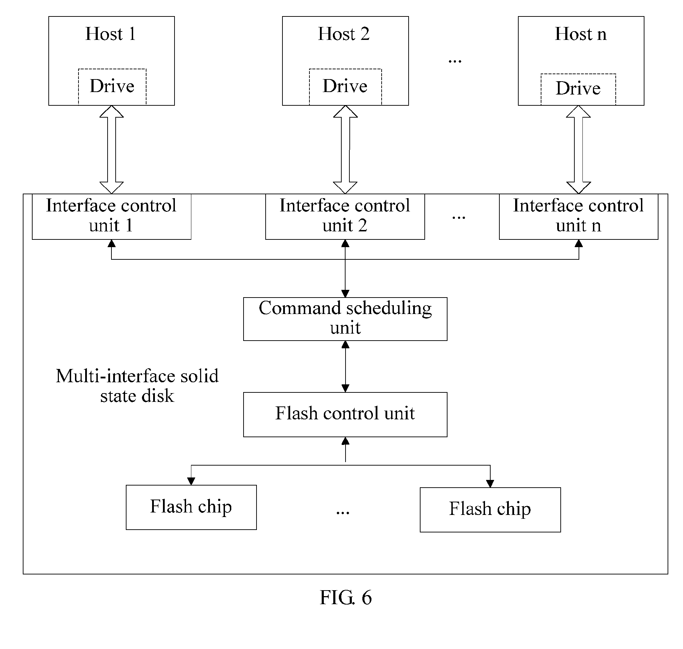

In the embodiment of the present invention, an example is taken to specifically illustrate the processing system of the multi-interface SSD, where the system includes multiple hosts and a multi-interface SSD, and each of the hosts includes a communication interface. As shown in FIG. 6, the system includes multiple hosts and a multi-interface SSD.

Each host is disposed with an interface communicating with the multi-interface SSD, and is connected to the multi-interface SSD through the interface. When the host successfully runs a multi-interface SSD drive, a direct communication connection may be achieved between the host and the multi-interface SSD. Moreover, the multi-interface SSD is used as a storage device of the host.

For example, a host 1, a host 2, ... and a host n are respectively connected to the multi-interface SSD through a communication interface 1, a communication interface 2, ... and a communication interface n (not shown in the figure) of the multi-interface SSD. When the host 1, the host 2, ... and the host n send operating commands to the multi-interface SSD, an interface control unit 1, and an interface control unit 2, ... and an interface control unit n that are one-to-one correspond to the communication interface 1, the communication interface 2, ... and the communication interface n respectively receive the operating commands sent by the host 1, the host 2, ... and the host n.

Different hosts are connected to the same SSD through different communication interfaces. Different hosts run their own multi-interface SSD drives, and all initialize the multi-interface SSD to be an independent storage device of the hosts, so that the multi-interface SSD that is connected to the multiple hosts is shown as an independent storage device on the different hosts. The size and range of accessed space of the multi-interface SSD accessed by each host is the size of the storage device presented externally by the multi-interface SSD.

Specifically, for the processing, by the multi-interface SSD, the operating commands received by the multiple interface control units, reference may be made to the descriptions in the first embodiment, the second embodiment and the third embodiment, which is not repeatedly described here.

In the embodiment of the present invention, the multiple communication interfaces are disposed in the multi-interface SSD, so that different hosts are directly connected to an SSD interface for communication through the different communication interfaces, thus avoiding the problem that when multiple hosts share the SSD, except a host that is directly connected to the SSD, other hosts need to access the SSD indirectly, so that different hosts may directly access the SSD concurrently, and do not need to perform accessing by a sharing manner between each other. Therefore, an access bandwidth is increased and requirements of each host for features, such as high performance, wide bandwidth and high capacity, of the SSD are satisfied.

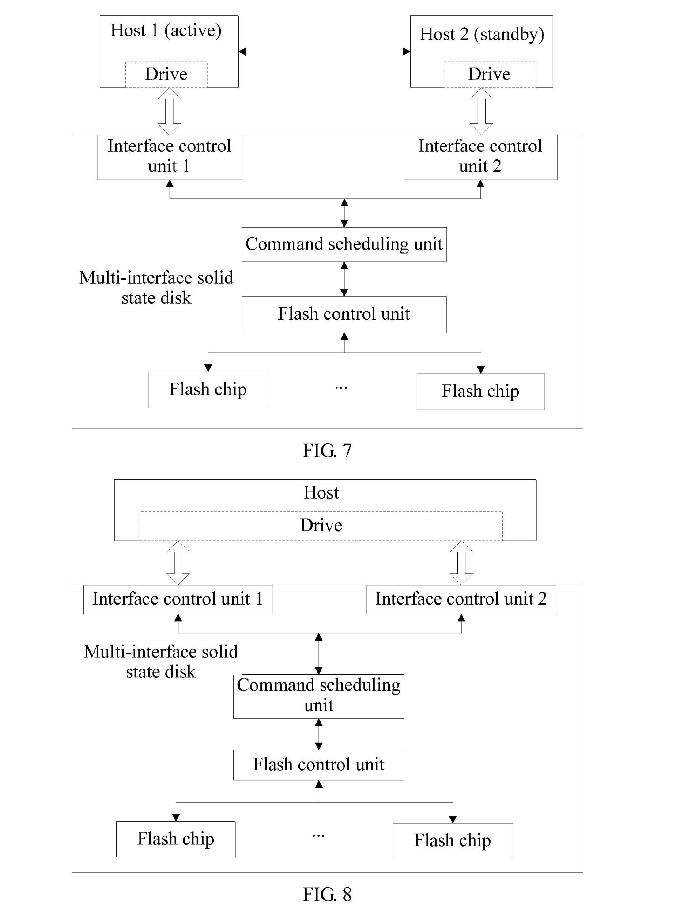

An embodiment of the present invention further provides a processing system of a multi-interface SSD, where an active-standby relationship may be set for a host that is directly connected to a multi-interface SSD. In the embodiment of the present invention, an example is taken to specifically illustrate the processing system, where a multi-interface SSD includes two communication interfaces. As shown in FIG. 7, the system includes two hosts (a host 1 and a host 2) and a multi-interface SSD.

Each of the two hosts includes an interface connected to the multi-interface SSD, and is connected to the multi-interface SSD through the interface. When the hosts successfully run an SSD drive, the host 1 and the host 2 are both capable of accessing the multi-interface SSD independently. In specific implementation, the host 1 may be set to be an active device, and the host 2 may be set to be a standby device. Moreover, a link connection is kept between the host 1 and the host 2. The host 1 and the host 2 are connected to the multi-interface SSD respectively through a communication interface 1 and a communication interface 2 of the multi-interface SSD. When the system is normal, merely the host 1 is used to communicate with the multi-interface SSD, and the standby device does not access the SSD. When the host 1 fails, the standby host 2 starts to access the SSD.

When the system is normal, the host 1 sends an operation command through the communication interface 1 of the multi-interface SSD to the multi-interface SSD, and an interface control unit 1 receives the operating command through the communication interface 1.

When the host 1 fails, the host 2 sends an operating command through the communication interface 2 of the multi-interface SSD to the multi-interface SSD, and an interface control unit 2 receives the operating command through the communication interface 2.

Specifically, for the processing, by the multi-interface SSD, the operating commands received by the multiple interface control units, reference may be made to the descriptions in the first embodiment, the second embodiment and the third embodiment, which is not repeatedly described here.

In the embodiment of the present invention, the active/standby relationship is set between different hosts that are connected to the multi-interface SSD. When an active host fails, a standby host may continue to execute a corresponding operation, so that reliability of the system is improved.

An embodiment of the present invention further provides a processing system of a multi-interface SSD, where a host that communicates with a multi-interface SSD may be set as a host having multiple communication interfaces. In the embodiment of the present invention, an example is taken to specifically illustrate the processing system, where the host is set to be a host having two communication interfaces. As shown in FIG. 8, the system includes:
a host and a multi-interface SSD, where the host includes a multi-interface SSD drive and two interfaces that are capable of communicating with the multi-interface SSD. An interface 1 and an interface 2 of the host are respectively connected to a communication interface 1 and a communication interface 2 (not shown in the figure) of the multi-interface SSD. Each interface of the host may independently access the multi-interface SSD through running of the multi-interface SSD drive. Moreover, it is shown on the host that two independent multi-interface SSDs are connected to the host. In specific implementation, the host may send an operating command through one of the two interfaces to the multi-interface SSD, and may also send operating commands through the two interfaces to the multi-interface SSD at the same time. When the operating commands are sent through the two interfaces to the multi-interface SSD at the same time, it is shown on the host side that the host may access two multi-interface SSDs at the same time. Therefore a bandwidth between the host and the multi-interface SSD is widened, so that performance of the SSD may be better exerted.

Specifically, for the processing, by the multi-interface SSD, the operating commands received by the multiple interface control units, reference may be made to the descriptions in the first embodiment, the second embodiment and the third embodiment, which is not repeatedly described here.

In the embodiment of the present invention, multiple interfaces are disposed at the same host. The multiple interfaces are connected to different communication interfaces of the multi-interface SSD. After a multi-interface SSD drive program of the host is run, the multiple interfaces of the host may send operating commands to the multi-interface SSD concurrently. An interface bandwidth between the host and the SSD is widened. Different hosts may directly access a solid state disk of the solid state disk card concurrently. An access bandwidth is increased, and requirements of each host for features, such as high performance, wide bandwidth and high capacity, of the SSD of the SSD card are satisfied.

Through the foregoing descriptions of the implementation, persons skilled in the art may clearly understand that the present invention may be implemented by software plus necessary universal hardware, and definitely may also be implemented by hardware, but in many cases, the former is preferred. Based on such understanding, the technical solutions of the present invention or the part that makes contributions to the prior art can be substantially embodied in the form of a software product. The computer software product may be stored in a readable storage medium, for example, a floppy disk, a hard disk, or an optical disk of the computer, and includes several instructions used to instruct a computer device (for example, a personal computer, a server, or a network device) to perform the method described in the embodiments of the present invention.

The foregoing descriptions are only the specific implementation of the present invention, but are not intended to limit the protection scope of the present invention. Any variation or replacement that may be easily thought of by persons skilled in the art within the technical scope disclosed by the present invention shall fall within the protection scope of the present invention. Therefore, the protection scope of the present invention shall be subject to the protection scope of the claims.

## Claims

1. A multi-interface solid state disk, comprising:
multiple interface control units, a command scheduling unit, a flash control unit and a flash chip, wherein each interface control unit respectively corresponds to a communication interface;
the interface control unit is configured to receive an operating command through the communication interface;
the command scheduling unit is configured to obtain operating commands from the multiple interface control units according to a scheduling rule, and put the operating commands in a command queue;
the command scheduling unit is further configured to take an operating command from the command queue and send the operating command to the flash control unit; and
the flash control unit is configured to convert the received operating command into a flash operating command, and operate the flash chip through the flash operating command.

2. The multi-interface solid state disk according to claim 1, wherein the command scheduling unit is configured to receive the operating commands from the multiple interface control units according to the scheduling rule, which comprises:
the command scheduling unit obtains the operating commands according to a polling principle of the multiple communication interfaces, or according to a principle regarding numbers of the multiple communication interfaces in which a lower number has the priority or a higher number has the priority.

3. The multi-interface solid state disk according to claim 1, wherein the command scheduling unit is further configured to:
judge, after taking an operating command from the command queue, whether the operating command is formed by multiple commands;
if it is judged that the operating command is formed by multiple commands, divide the operating command into multiple commands and send the multiple commands to the flash control unit; and
if it is judged that the operating command is formed by one command, send the one command to the flash control unit.

4. The multi-interface solid state disk according to claim 1, wherein the communication interface is an enhanced peripheral component interconnect PCIe interface.

5. A processing method of a multi-interface solid state disk, comprising:
receiving operating commands through multiple communication interfaces;
obtaining, according to a scheduling rule, the operating commands received from the multiple communication interfaces, and putting the operating commands in a command queue;
taking an operating command from the command queue;
converting the operating command into a flash operating command, and operating a flash chip in the solid state disk.

6. The method according to claim 5, wherein the obtaining, according to the scheduling rule, the operating commands received from the multiple communication interfaces comprises:
obtaining the operating commands according to a polling principle of the multiple communication interfaces, or according to a principle regarding numbers of the multiple communication interfaces in which a lower number has the priority or a higher number has the priority.

7. The method according to claim 5, wherein after the taking an operating command from the command queue, the method further comprises:
judging whether the operating command is formed by multiple commands;
if it is judged that the operating command is formed by multiple commands, dividing the operating command into multiple commands, converting the multiple commands into multiple corresponding flash operating commands and operating the flash chip in the solid state disk; and
if it is judged that the operating command is formed by one command, converting the one command into a corresponding flash operating command and operating the flash chip in the solid state disk.

8. A processing system of a multi-interface solid state disk, comprising at least one host and at least one multi-interface solid state disk, wherein
the host comprises a multi-interface solid state disk drive, a direct communication connection between the host and the multi-interface solid state disk is achieved by running of the drive, and the host is configured to send an operating command to the multi-interface solid state disk; and
the multi-interface solid state disk comprises multiple interface control units, a command scheduling unit, a flash control unit and a flash chip, each interface control unit respectively corresponds to a communication interface; the interface control unit is configured to receive, through the communication interface, the operating command sent by the host; the command scheduling unit is configured to obtain operating commands from the multiple interface control units according to a scheduling rule, and put the operating commands in a command queue; the command scheduling unit is further configured to take an operating command from the command queue and send the operating command to the flash control unit; and the flash control unit is configured to convert the received operating command into a flash operating command and operate the flash chip through the flash operating command.

9. The system according to claim 8, wherein when the hosts are two hosts and the host is a host connected to at least one communication interface of the multi-interface solid state disk, the system further comprises:
setting one host to be an active device and setting the other host to be a standby device, wherein link communication is kept between the active device and the standby device.

10. The system according to any one of claims 7 to 9, wherein the communication interface is an enhanced peripheral component interconnect PCIe interface.
